(19) **Europäisches Patentamt**

**European Patent Office**

**Office européen des brevets**

(11) **EP 1 188 356 B1**

(12) **EUROPEAN PATENT SPECIFICATION**

(45) Date of publication and mention
of the grant of the patent:
**23.04.2003 Bulletin 2003/17**

(21) Application number: **00940444.3**

(22) Date of filing: **22.06.2000**

(51) Int Cl.⁷: **H05K 9/00**

(86) International application number:
**PCT/FI00/00569**

(87) International publication number:
**WO 01/001744 (04.01.2001 Gazette 2001/01)**

(54) **A PROTECTING DEVICE AGAINST INTERFERING ELECTROMAGNETIC RADIATION COMRPISING EMI-GASKETS**

SCHUTZVORRICHTUNG GEGEN ELEKTROMAGNETISCHE STRAHLUNG MIT DICHTUNGEN

DISPOSITIF DE PROTECTION CONTRE LES INTERFERENCES ELECTROMAGNETIQUES COMPORTANT DES JOINTS ANTI-EMI

(84) Designated Contracting States:
**DE FR GB IT**

(30) Priority: **24.06.1999 FI 991453**

(43) Date of publication of application:
**20.03.2002 Bulletin 2002/12**

(73) Proprietor: **Nokia Corporation**
**02150 Espoo (FI)**

(72) Inventor: **NURMI, Reijo**
**FIN-90230 Oulu (FI)**

(74) Representative: **Stellberg, Hans**
**Forssén & Salomaa Oy**
**Eerikinkatu 2**
**00100 Helsinki (FI)**

(56) References cited:
**WO-A1-94/30035**     **US-A- 4 780 570**
**US-A- 5 313 016**     **US-A- 5 474 309**

## Description

The present invention relates to protecting devices against interfering electromagnetic radiation.

Electromagnetic radiation generated in a device may disturb either the device's own operation or the operation of some external device. Generally, the aim is to protect sensitive devices and interfering sources of electromagnetic radiation against radiation by encasing them in packages made from a conductive material and by sealing the packages so tight that no interfering electromagnetic radiation can penetrate the package. This type of or similar protection of devices against electromagnetic radiation is called EMI (electromagnetic interference) shielding.

One problematic area in EMI shielding is the sealing of junctions and joint surfaces comprised by devices, device cabinets and boxes. If the joint surfaces are not properly sealed with EMI gaskets, interfering electromagnetic radiation will quite easily pass through the joint. The best protection against interference is achieved when the joint surfaces are tightly sealed together galvanically. This means that resistance between the joint surfaces, so-called 'junction resistance', is as low as possible. However, it is difficult and expensive to manufacture such plane-like joint surfaces, where the surfaces are tightly attached to each other in every place galvanically. Therefore, solutions in which a good contact between the joint surfaces is not formed in every place but at certain distances along the whole length of the joint, are used for sealing joint surfaces. When the distance between the contacts formed is sufficiently short, electromagnetic radiation can no longer penetrate the joint in disturbing quantities. A sufficient contact distance depends on the frequency of the interfering radiation and the required attenuation level. Mechanical properties and the available space also affect the contact distance used. In connection with device cabinets and racks, a typical contact distance can be, e.g. 5 - 15 mm.

EMI sealing is required in various types of electric devices. Among others, EMI gaskets are used in device box and cabinet doors and apertures, as well as in partitions between different units inside device cabinets.

There are at least three types of gaskets that are most commonly used for EMI sealing. In one solution, a mantle is knitted from a conductive material around a resilient rubber compound or some other corresponding material. The mantle is knitted from a very thin wire that acts as a conductive fabric. When placed in between joint surfaces, these types of gaskets give an even contact but do not necessarily give a sufficient contact for EMI shielding due to the large contact area. They do not pierce through the surface, which is slightly oxidised or greasy. These types of gaskets may shed short pieces of wire, which can cause a short circuit after being passed on to a printed board. Neither do they endure friction and continuous wear.

In a second solution conductive particles are mixed inside a rubber-like sealing compound, the conductive particles forming a galvanic connection between joint surfaces when the joint surfaces are pressed together. However, the electroconductivity of these types of gaskets does not come near to that of, e.g. copper alloyed gaskets. Furthermore, the properties of these types of gaskets may change as they age.

A third solution is provided by spring-like gaskets bent from sheet metal. Their electroconductivity is good, but their manufacture is problematic. The manufacture of spring-like sheet metal gaskets requires expensive perforating and bending tools. In addition, the edges of the gaskets are sharp, whereupon one may hurt one's hand on them, and the length of the gaskets is limited to the length of the sheet used in their manufacture, which normally is about 70 cm, in which case a full-length gasket must be assembled from several pieces.

The most significant disadvantage of a spring-like sheet metal gasket is, however, its susceptibility to being damaged due to its poor elastic properties. The gasket has extremely accurate tolerance of compression. If joint surfaces are pressed together too little, the gasket placed in between them will leak, as it is called, i.e. let electromagnetic radiation significantly through it. If again joint surfaces are pressed too much, a permanent deformation will take place in the gasket and its compression force will no longer be sufficient. Also in this case, the joint will begin to leak.

Figure 1 illustrates an EMI gasket presented in the Patent Publication US 5 091 606, which comprises a helical spring 10 made from a circular profiled wire and may comprise a layer 11 made on top of the spring from a conductive and ductile material. When this type of gasket is placed in between the surfaces to be sealed and the surfaces are pressed against each other, a contact is formed between the surfaces. The gasket is intended for sealing shafts and other surfaces with a circular cross-section, and their circumferences. A disadvantage of these types of gaskets is a reasonably complex manufacturing process, as well as the difficulty of fitting the gasket into small spaces.

Now, EMI sealing has been invented with the help of which the disadvantages presented above can be mitigated. This can be achieved with a device, which comprises a first part and a second part connected to each other, as well as an EMI gasket in between them for preventing electromagnetic interference from penetrating the joining point between the first and second parts, the device being characterised in that said first part comprises an aperture through which at least part of the EMI gasket can go through for attaching the EMI gasket to said first part and for limiting the longitudinal motion of the EMI gasket.

According to the invention, an EMI gasket is made from a spring-like, electroconductive wire that is bent in the appropriate shape, depending on the use.

The EMI gasket is suited, e.g. for the EMI sealing of a joint between specific first and second mechanical parts of a component cabinet, rack or package so that the EMI gasket is placed substantially inside the first part. This said first part comprises a rear surface against which the EMI gasket leans and apertures on its joint surface through which the EMI gasket comes out partly enabling the formation of a contact with the rear surface of said first part and the joint surface of said second part. When the joint surfaces are attached against each other, interfering electromagnetic radiation cannot significantly penetrate the produced EMI joint.

In the following, the invention will be explained in detail by referring to the enclosed drawings, in which

Figure 1 shows an EMI gasket according to prior art;

Figures 2a - 2c show one way of EMI sealing according to the invention;

Figures 3a - 3c show another way of EMI sealing according to the invention;

Figures 4a - 4b show one way of attaching an EMI gasket to an edge of a printed board according to the invention;

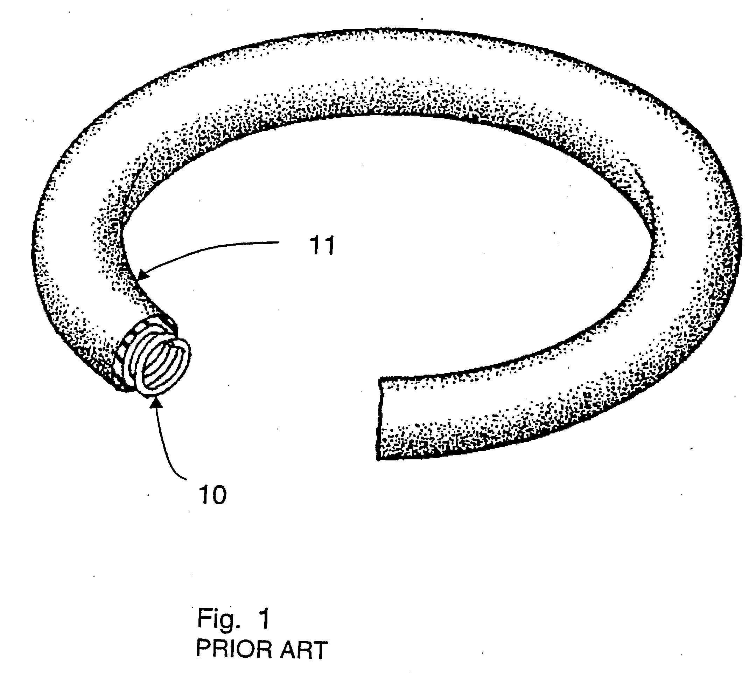

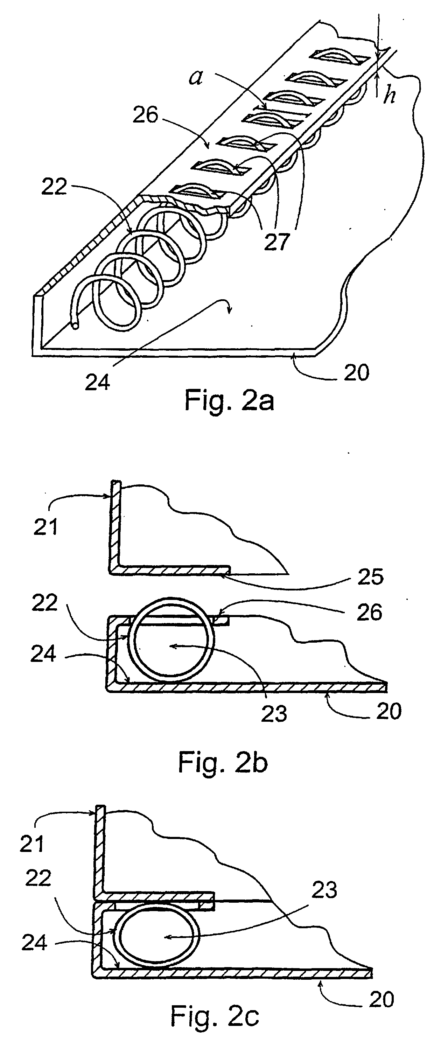

Figure 1 was described above in connection with the description of prior art. Figures 2a - 2c are related to a first embodiment according to the invention, in which a joint surface between a specific first part 20 and a specific second part 21 is sealed EMI tight. Said parts can be mechanical parts of a device cabinet, rack or package made, e.g. from an electroconductive material, such as sheet metal. The devices mentioned here can be, e.g. devices in a mobile communication network. An EMI gasket is placed substantially inside said first part 20. For this, said first part 20 preferably comprises a recess 23 into which an EMI gasket 22 can be pushed. Said first part 20 also comprises a rear surface 24 against which the EMI gasket 22, pushed into the recess 23, may lean. On its joint surface 26, said first part 20 comprises apertures 27 through which the gasket 22 according to the invention can go partly through enabling the formation of a contact between the rear surface 24 of the first part 20 and the joint surface 25 of the second part 21 when pressing the parts together.

Figure 2a illustrates a situation, where the EMI gasket 22, preferably bent in the shape of a helical spring, is placed inside the first part 20 according to the invention. The gasket 22 leans on the rear surface 24 of the first part and comes partly through the apertures 27 that are perpendicular to the axis of the gasket 22, which apertures are made in the joint surface 26 of the first part 20. The apertures 27 limit the longitudinal motion of the EMI gasket 22.

Before joining the joint surfaces 25, 26, they are matched together (Figure 2b). When the joint surfaces 25, 26 are next pressed against each other (Figure 2c), a compression is produced on the gasket 22. The elastic forces that act in the compressed gasket 22 tend to return the gasket into its original shape, whereupon the gasket 22 presses tightly between the rear surface 24 of said first part 20 and the joint surface 25 of the second part 21 forming contacts between the surfaces, whereupon interfering electromagnetic radiation is prevented from penetrating the joint between the first and second parts. The distance between two adjacent contacts is the same as the distance between the apertures 27 of the joint surface 26 of said first part 20, which typically is approximately 5 - 15 mm.

The EMI gasket 22 according to the invention can be bent in several different shapes, but in this embodiment it is preferably bent in the shape of a helical spring. The gasket 22 can be made from several different materials, e.g. from alloyed copper metal, stainless steel or other corresponding material. The gasket's electrical and mechanical properties, as well as manufacturability can be affected by the selection of the sealing material. The diameter of the wire used for the manufacture of the gasket 22 may vary, but it is typically approximately 0.5 - 3 mm. The sealing wire is bent in the required shape by a spring-making machine designed for bending wire material. The diameter of the gasket 22 can be, e.g. 2 - 40 mm. The length $a$ of the apertures 27 preferably satisfies the inequality

$$a > 2 \cdot \sqrt{dh\text{-}h^2},$$

where d is the diameter of the EMI gasket 22 and h is the thickness of the surface 26 that comprises the apertures 27. When the inequality is satisfied, the EMI gasket 22 can go through the apertures 27 to touch the joint surface (25) of said second part (21) assuming that the diameter of the sealing wire is smaller than the width of the aperture.

In the implementation according to the invention, the joint surfaces 25, 26 are directly in contact, against each other. Because there is no significant air gap between the surfaces 25, 26, the joint is quite dustproof. The use of the EMI gasket 22 enables the formation of effective contacts at short distances in the longitudinal direction of the gasket 22 between said rear surface 24 of the first part and said joint surface 25 of the second part 21, whereupon interfering electromagnetic radiation is prevented from penetrating the joint. Furthermore, the now invented EMI gasket 22 stays in its place without supplementary parts.

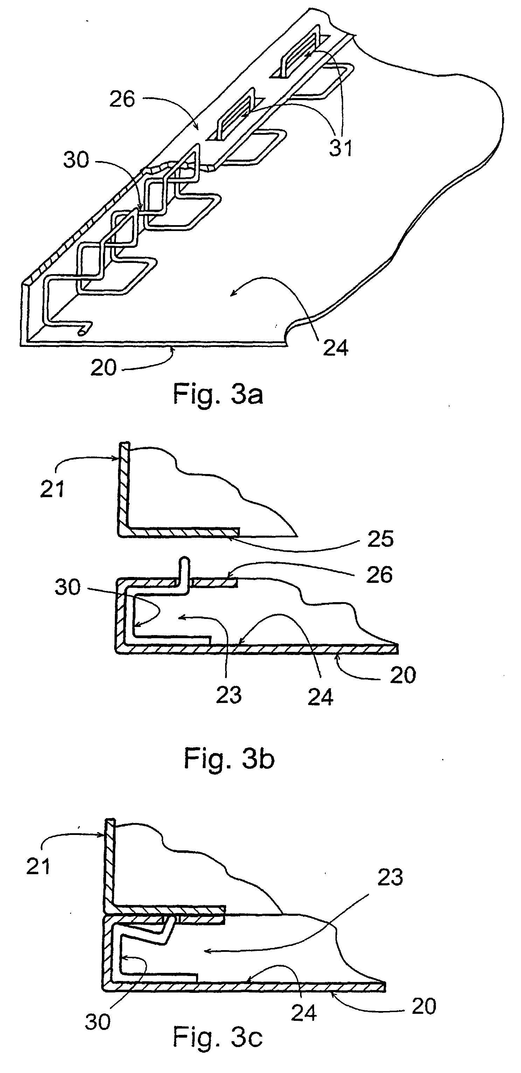

Figures 3a - 3c show a second embodiment according to the invention, in which apertures 31 in the joint surface 26 of said first part 20 are parallel to the longitudinal axis of an EMI gasket 30. In this embodiment, the EMI gasket 30 is preferably bent to make a periodic spring-like structure so that along a specific length the gasket 30 comprises parts that are perpendicular to the longitudinal axis of the gasket and parts that are parallel to the longitudinal direction of the gasket 30. Figure 3a shows one possible form of bending, where the folds of the sealing wire are substantially 90 degrees each. When the EMI gasket 30 is put in its place in a recess 23 comprised by the first part 20, the gasket 30 comes partly through the apertures 31, which are made in the joint surface 26 of the first part 20. The length of the apertures 31 is substantially the same as the length of the parts that are parallel to the longitudinal direction of the gasket 30.

The contacts that produce EMI tightness are formed in the second embodiment of the invention when the gasket 30 is pressed between the rear surface 24 of the first part 20 and the joint surface 25 of the second part 21 (Figures 3b - 3c). The contacts are formed on somewhat longer areas, i.e. longer portions of the wire than in the first embodiment.

If there is a desire to make the EMI gasket 22, 30 ready in the desired shape, a rigid support wire placed inside the gasket can be utilised in bending the gasket. The support wire is first bent in the desired shape, e.g. in the shape of the edge of a component rack, after which the gasket 22, 30 is slipped on to the support wire. Finally, the gasket with the support wire is placed in the space reserved for it.

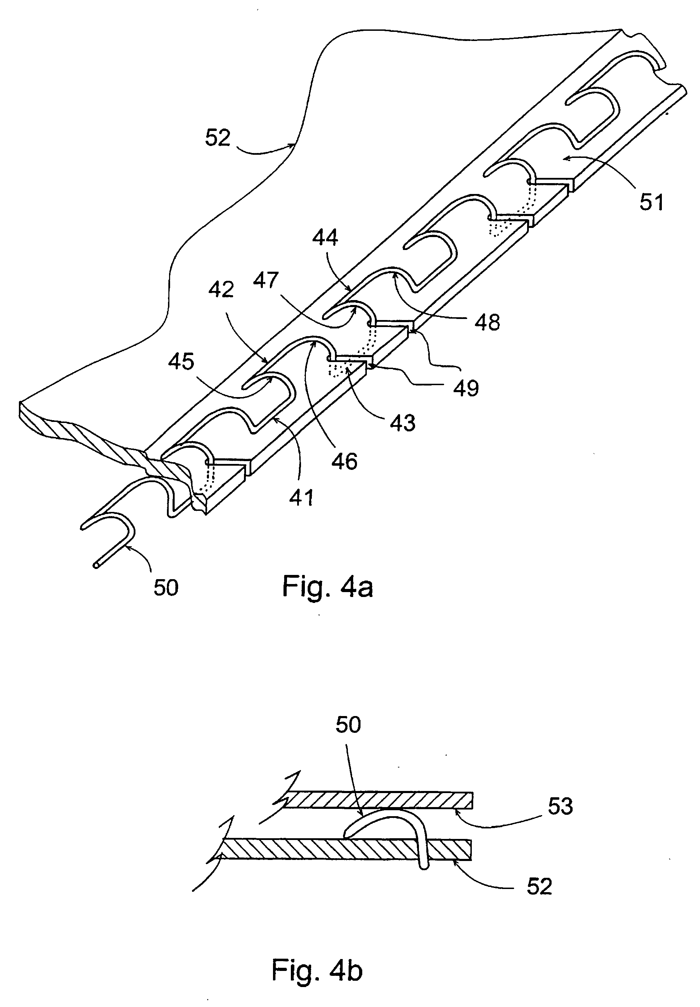

The apertures 27, 31 can also be made on the edge of a sheet, whereupon they are called notches. Figures 4a and 4b are related to a third embodiment according to the invention, which presents a method for attaching an EMI gasket 50 to the edge of a printed board 52. The EMI gasket 50 presented in this embodiment does not take space on the other side of the board 52, but it can be attached to the edge of the board 52 without external attachment elements. Furthermore, its elastic distance can be easily adjusted by shaping the wire.

The printed board 52, whereto the EMI gasket 50 is attached, comprises on its edge two notches 49 at a specific first distance from each other and on its surface, as ground plane, an electroconductive area 51, which can be made, e.g. from electroconductive metal film; foil.

The EMI gasket 50 used for sealing is a periodic gasket, one period of which comprising when proceeding in the longitudinal direction of the gasket 50 the following portions, in sequence: a first straight portion 41; a first curved portion 45; a second straight portion 42; a second curved portion 46; a third straight portion 43; a third curved portion 47; a fourth straight portion 44; and a fourth curved portion 48. When the EMI gasket is free, the first and third 41, 43 of its straight portions (the second and fourth 42, 44 respectively) settle substantially in line with each other on a straight line that is parallel to the longitudinal axis of the EMI gasket 50. Said curved portions 45 - 48 belong to planes, the normal of which is the longitudinal axis of the gasket 50.

The EMI gasket 50 is pushed to the edge of the printed board 52 so that the second and third curved portions 46, 47 are pressed into the notches 49 on the edge of the printed board, whereupon the longitudinal motion of the EMI gasket 50 is limited. Said third straight portion 43 is stretched underneath the edge of the printed board 52, on the side of the assumed bottom surface of the printed board 52. From this pretension, the gasket 50 obtains its aggregation force and stays in its place.

The other straight portions 41, 42 and 44 settle on the assumed upper surface of the printed board 52, i.e. on the surface where the electroconductive area 51 that acts as ground plane, is located. All said curved parts 45 - 48 project at least partly from the plane of the assumed upper surface of the printed board 52. Thus, along the whole length of the EMI gasket 50, every fourth straight portion 43 settles on the side of the assumed bottom surface of the printed board 52 and the rest, on the assumed upper surface, whereupon the EMI gasket 50 attaches itself effectively to the printed board 52.

In order to achieve EMI tightness through the joint between the printed board 52 comprising the EMI gasket 50 and some other specific electroconductive counter-surface 53, said parts must be pressed against each other (Figure 4b). When pressing said second counter-surface 53 against the EMI gasket 50 attached to the printed board 52, a compression is produced on the EMI gasket. The elastic forces that act in the compressed gasket 50 tend to return the gasket into its original shape, whereupon the flexible gasket 50 presses tightly against the surfaces 51, 53 that are in contact with it. This being the case, firm electric contacts are formed through the EMI gasket 50 between said second counter-surface 53 and the conductive area 51 that acts as the printed board's ground plane, joined together, at short, regular distances along the whole length of the joint preventing electromagnetic radiation from penetrating the joint.

This paper presents the implementation and embodiments of the invention with the help of examples. A person skilled in the art will appreciate that the present invention is not restricted to details of the embodiments presented above and that the invention can also be implemented in another form without deviating from the characteristics of the invention. The presented embodiments should be regarded as illustrative but not restricting. Thus, the possibilities of implementing and using the invention are only restricted by the enclosed claims, and the various options of implementing the invention as determined by the claims, including the equivalent implementations, also belong to the scope of the invention.

## Claims

1.  A device that comprises a first part (20, 52) and a second part (21, 53), joined together, and in between them an EMI gasket (22, 30, 50) for preventing electromagnetic interference from passing through the joining point between the first and second parts, **characterised in that**

the EMI gasket (22, 30, 50) comprises a continuous elongated structure, the structure comprising a portion which portion is regularly repeated in the EMI gasket;

the first part (20, 52) comprises in a first planar surface a set of elongated apertures (27, 31, 49) through which at least part of the regularly repeated portions of the EMI gasket (22, 30, 50) fit for limiting the longitudinal motion of the EMI gasket, wherein

along a length defined by the regularly repeated portions, the EMI gasket is adapted to be attached to said first part (20, 52) with the aid of the set of apertures (27, 31, 49) in the first planar surface only.

2. A device according to claim 1, **characterised in that** said first part (20) and said second part (21) comprise a first joint surface (26) and a second joint surface (25) respectively, and that

the EMI gasket (22, 30) is in contact with said first part (20) and that

each of said apertures is a hole (27, 31) made in said first joint surface (26), through which hole part of the EMI gasket (22, 30) can go through for limiting the longitudinal motion of the EMI gasket and for forming a contact between the EMI gasket (22, 30) and said second part (21) and, thus, for forming an electrical contact between said first part (20) and said second part (21).

3. A device according to claim 1, **characterised in that** each of said apertures is a notch (49) made on the edge of said first part (52).

4. A device according to claim 1, **characterised in that** said first part (20, 52) and said second part (21, 53) are mechanical parts of a device cabinet.

5. A device according to claim 1, **characterised in that** said EMI gasket (22) is manufactured from an electroconductive wire, in a helical spring-like shape.

6. A device according to claim 1, **characterised in that** said EMI gasket (30) comprises along a particular length parts that are perpendicular to the longitudinal axis of the gasket (30) and parts that are parallel to the longitudinal direction of the gasket (30).

7. A device according to claim 2, **characterised in that** said first part (20) comprises a recess (23) for the EMI gasket (22, 30) and a specific rear surface (24), whereupon when part of the gasket goes through said hole (27, 31) the remaining part of the EMI gasket remains in said recess (23) touching said rear surface (24).

8. A device according to claim 2, **characterised in that** said hole (27) is elongated and perpendicular to the longitudinal axis of the EMI gasket (22).

9. A device according to claim 2, **characterised in that** said hole (31) is elongated and parallel to the longitudinal axis of the EMI gasket (30).

10. A device according to claim 7, **characterised in that** the EMI gasket forms a contact between said rear surface (24) and said second joint surface (25).

**Patentansprüche**

1. Vorrichtung, die einen ersten Teil (20, 52) und einen zweiten Teil (21, 53), die zusammen verbunden sind, sowie dazwischen eine EMI-Dichtung (22, 30, 50) zur Verhinderung umfasst, dass eine elektromagnetische Störung durch den Verbindungspunkt zwischen dem ersten und dem zweiten Teil hindurch geht, **dadurch gekennzeichnet, dass**

die EMI-Dichtung (22, 30, 50) einen durchgehenden verlängerten Aufbau umfasst, wobei der Aufbau einen Abschnitt umfasst, wobei der Abschnitt regelmäßig in der EMI-Dichtung wiederholt wird,

der erste Teil (20, 52) in einer ersten ebenen Oberfläche einen Satz von verlängerten Öffnungen (27, 31, 49) umfasst, durch die zumindest ein Teil der regelmäßig wiederholten Abschnitte der EMI-Dichtung (22, 30, 50) passt, um die longitudinale Bewegung der EMI-Dichtung zu begrenzen, wobei

entlang einer durch die regelmäßig wiederholten Abschnitte definierten Länge die EMI-Dichtung angepasst ist, bei dem ersten Teil (20, 52) mit Hilfe des Satzes von Öffnungen (27, 31, 49) lediglich in der ersten ebenen Oberfläche angebracht zu sein.

2. Vorrichtung nach Anspruch 1, **dadurch gekennzeichnet, dass** der erste Teil (20) und der zweite Teil (21) eine erste Verbindungsoberfläche (26) bzw. eine zweite Verbindungsoberfläche (25) umfassen und dass

die EMI-Dichtung (22, 30) in Kontakt mit dem ersten Teil (20) ist und dass

jede der Öffnungen ein Loch (27, 31) ist, das in der ersten Verbindungsoberfläche (26) ausgebildet ist, wobei durch das Loch ein Teil der EMI-Dichtung (22, 30) hindurch gehen kann, um die longitudinale Bewegung der EMI-Dichtung zu begrenzen und um einen Kontakt zwischen der EMI-Dichtung (22, 30) und dem zweiten Teil (21) zu bilden, um somit einen elektrischen Kontakt zwischen dem ersten Teil (20) und dem zweiten Teil (21) zu bilden.

3. Vorrichtung nach Anspruch 1, **dadurch gekennzeichnet, dass** jede der Öffnungen eine Kerbe (49) ist, die bei dem Rand des ersten Teils (52) ausgebildet ist.

4. Vorrichtung nach Anspruch 1, **dadurch gekennzeichnet, dass** der erste Teil (20, 52) und der zweite Teil (21, 53) mechanische Teile eines Vorrichtungsgehäuses sind.

5. Vorrichtung nach Anspruch 1, **dadurch gekennzeichnet, dass** die EMI-Dichtung (22) aus einem elektrisch leitenden Draht in einer schraubenfederartigen Form hergestellt ist.

6. Vorrichtung nach Anspruch 1, **dadurch gekennzeichnet, dass** die EMI Dichtung (30) entlang einer bestimmten Länge Teile, die senkrecht zu der longitudinalen Achse der Dichtung (30) sind, und Teile, die parallel zu der longitudinalen Richtung der Dichtung (30) sind, umfasst.

7. Vorrichtung nach Anspruch 2, **dadurch gekennzeichnet, dass** der erste Teil (20) eine Vertiefung (23) für die EMI-Dichtung (22, 30) und eine spezifische Rückfläche (24) umfasst, wobei, wenn ein Teil der Dichtung durch das Loch (27, 31) geht, der verbleibende Teil der EMI-Dichtung in der Vertiefung (23) bleibt, wobei die Rückfläche (24) berührt wird.

8. Vorrichtung nach Anspruch 2, **dadurch gekennzeichnet, dass** das Loch (27) verlängert ist und senkrecht zu der longitudinalen Achse der EMI-Dichtung (22) ist.

9. Vorrichtung nach Anspruch 2, **dadurch gekennzeichnet, dass** das Loch (31) verlängert ist und parallel zu der longitudinalen Achse der EMI-Dichtung (22) ist.

10. Vorrichtung nach Anspruch 7, **dadurch gekennzeichnet, dass** die EMI-Dichtung einen Kontakt zwischen der Rückfläche (24) und der zweiten Verbindungsoberfläche (25) bildet.

**Revendications**

1. Dispositif comprenant une première partie (20, 52) et une deuxième partie (21, 53), jointives ensemble, et entre elles un joint IEM (22, 30, 50) pour empêcher les interférences électromagnétiques de traverser le point de contact entre les première et deuxième parties, **caractérisé en ce que**

le joint IEM (22, 30, 50) comprend une structure allongée continue, la structure comprenant un segment lequel segment est régulièrement répété dans le joint IEM;

la première partie (20, 52) comprend dans une première surface plane une pluralité d'ouvertures allongées (27, 31, 49) dans lesquelles au moins partiellement des segments régulièrement répétés du joint IEM (22, 30, 50) sont positionnés pour limiter le mouvement longitudinal du joint IEM, où

sur une longueur définie par les segments régulièrement répétés, le joint IEM est adapté pour être solidaire de ladite première partie (20, 52) à l'aide de la pluralité d'ouvertures (27, 31, 49) uniquement dans la première surface plane.

2. Dispositif selon la revendication 1, **caractérisé en ce que** ladite première partie (20) et ladite deuxième partie (21) comprennent respectivement une première surface de contact (26) et une deuxième surface de contact (25), et **en ce que**

le joint IEM (22, 30) est en contact avec ladite première partie (20) et **en ce que**

chacune desdites ouvertures est un orifice (27, 31) réalisé dans ladite première surface de contact (26), par lequel orifice une partie du joint IEM (22, 30) peut traverser pour limiter le mouvement longitudinal du joint IEM et pour réaliser un contact entre le joint IEM (22, 30) et ladite deuxième partie (21) et, ainsi, pour former un contact électrique entre ladite première (20) et ladite deuxième partie (21).

3. Dispositif selon la revendication 1, **caractérisé en ce que** chacune desdites ouvertures est un cran (49) réalisé sur le rebord de ladite première partie (52).

4. Dispositif selon la revendication 1, **caractérisé en ce que** ladite première partie (20, 52) et ladite deuxième partie (21, 53) sont des pièces mécaniques d'un coffret.

5. Dispositif selon la revendication 1, **caractérisé en ce que** ledit joint IEM (22) est fabriqué à partir d'un fil conducteur électriquement, en forme de ressort hélicoïdal.

6. Dispositif selon la revendication 1, **caractérisé en ce que** ledit joint IEM (30) comprend le long des segments de longueur particulière qui sont perpendiculaires à l'axe longitudinal du joint (30) et des segments qui sont parallèles à la direction longitudinale du joint (30).

7. Dispositif selon la revendication 2, **caractérisé en ce que** ladite première partie (20) comprend une cavité (23) pour le joint IEM (22, 30) et une surface arrière spécifique (24), sur laquelle quand une partie du joint traverse ledit orifice (27, 31), la partie restante du joint IEM reste dans ladite cavité (23) en contact avec ladite surface arrière (24).

8. Dispositif selon la revendication 2, **caractérisé en ce que** ledit orifice (27) est allongé et perpendiculaire à l'axe longitudinal du joint IEM (22).

9. Dispositif selon la revendication 2, **caractérisé en ce que** ledit orifice (31) est allongé et parallèle à l'axe longitudinal du joint IEM (30).

10. Dispositif selon la revendication 7, **caractérisé en ce que** le joint IEM forme un contact entre ladite surface arrière (24) et ladite deuxième surface de contact (25).

11

10

Fig. 1
PRIOR ART

Fig. 2a

Fig. 2b

Fig. 2c

Fig. 3a

Fig. 3b

Fig. 3c

Fig. 4a

Fig. 4b